**Europäisches Patentamt**

**European Patent Office**

**Office européen des brevets**

(11) Veröffentlichungsnummer: **0 220 403**
**B1**

# EUROPÄISCHE PATENTSCHRIFT

(45) Veröffentlichungstag der Patentschrift:
**31.10.90**

(21) Anmeldenummer: **86111164.9**

(22) Anmeldetag: **12.08.86**

(51) Int. Cl.⁵: **H03H 15/00,** H03G 1/00,
H03F 3/60

(54) **Stufenweise einstellbare Kettenleiteranordnung.**

(30) Priorität: **30.09.85 DE 3534831**

(43) Veröffentlichungstag der Anmeldung:
**06.05.87 Patentblatt 87/19**

(45) Bekanntmachung des Hinweises auf die Patenterteilung:
**31.10.90 Patentblatt 90/44**

(84) Benannte Vertragsstaaten:
**DE FR GB IT NL**

(56) Entgegenhaltungen:
**US-A- 4 291 286**

**1982 IEEE MTT-S DIGEST, 15.-17. Juni 1982, Dallas,
Texas, Seiten 49-51, IEEE, New York, US; C.M.
PANASIK: "Hybrid FET/SAW programmable transversal
filter"
IEEE TRANSACTIONS ON ELECTRON DEVICES, Band
ED-31, Nr. 12, Dezember 1984, Seiten 1926-1930, IEEE,
New York, US; W. KENNAN et al.: "A 2-18 GHz
monolithic distributed amplifier using dual-gate GaAs
FET's"
IEEE TRANSACTIONS ON INSTRUMENTATION AND
MEASUREMENT , Band 24, Nr. 2, Juni 1975,
Seiten 106-112, IEEE, New York, US; K.B. KLAASEN:
"Digitally controlled absolute voltage division"**

(73) Patentinhaber: **Siemens Aktiengesellschaft,
Wittelsbacherplatz 2, D-8000 München 2(DE)**

(72) Erfinder: **Langer, Erik Prof.Dr.,
Ludwig-Hotter-Strasse 40, D-8952 Marktoberdorf(DE)**

## Beschreibung

Die Erfindung betrifft eine stufenweise einstellbare Kettenleiteranordnung nach dem Oberbegriff des Anspruchs 1.

Bei Mikrowellenschaltungen für die Richtfunk- und Radar-Technik ist es häufig erforderlich, die Sende- oder die Empfangskanäle auf eine genau vorgeschriebene Verstärkung einzustellen oder die Verstärkung schrittweise über viele Dezibel (z.B. 20 dB) elektronisch verändern zu können. Diese Forderung tritt insbesondere bei Phased Array-Radargeräten auf, wo man zur Optimierung der Strahlungscharakteristik außer der Phasen-Stufung häufig auch eine Amplituden-Stufung ("Wichtung") der Einzelkanäle vornimmt.

Zur schrittweisen Einstellung der Verstärkung bzw. Dämpfung von Hochfrequenz- und Mikrowellen-Kanälen werden üblicherweise mechanisch umschaltbare Ketten von Dämpfungsgliedern verwendet. Erfolgt die Umschaltung elektronisch, dann ist bei den entsprechenden Dioden- oder Transistor-Umschaltern eine oft störende zusätzliche Einfügedämpfung unvermeidbar. Diese Zusatzdämpfung geht auf Kosten des Einstellbereichs und der Maximalverstärkung.

Soll außerdem ein möglichst großer Dämpfungsbereich mit der minimal möglichen Anzahl von Dämpfungsgliedern überstrichen werden, dann müssen die Dämpfungsunterschiede der einzelnen Glieder entsprechend einer geometrischen Reihe mit $q = 2$ gestaffelt werden. Dabei sind an die Genauigkeit der Glieder mit großer Dämpfung hohe Anforderungen zu stellen, sonst ergeben sich unter Umständen unstetige (sinnwidrige) Dämpfungssprünge. Derartige Kettenglieder sind daher relativ toleranzempfindlich; so darf z.B. bei einer 1 dB-Staffelung der Dämpfung mit binär gestuften Kettengliedern (1, 2, 4, 8 ... dB) das 8 dB-Kettenglied nur einen negativen Fehler von weniger als 6,5 % aufweisen, wenn die 1-, 2- und 4-dB-Kettenglieder einen ebenso großen positiven Fehler von 6,5 % haben. Bei Überschreiten dieser Toleranzen würde sich in diesem Fall beim Übergang von der Kettenschaltung der "1 dB"-, "2 dB"- und "4 dB"-Kettenglieder zum "8 dB"-Kettenglied" nicht die erwünschte Zunahme der Dämpfung, sondern eine (unerlaubte) Dämpfungsabnahme ergeben. Je höher die Dämpfung eines Einzelkettengliedes ist, desto strenger werden die Toleranzforderungen bezüglich der Dämpfung dieses Einzelkettengliedes. Wenn beispielsweise bei der gerade beschriebenen Staffelung Kettenglieder mit 1, 2, 4, 8, 16 dB vorhanden sind, so darf das 16 dB-Kettenglied nur noch einen negativen Fehler von weniger als 3,17 % aufweisen. Die Kettenschaltung von Dämpfungsgliedern ist daher eine herstelltechnisch anspruchsvolle Methode zur Amplituden-Wichtung von Mikrowellensignalen.

Zur schrittweisen Einstellung der Kanalverstärkung kann man entweder schrittweise einschaltbare Ketten von Dämpfungsgliedern in den Verstärkerzug einschalten, oder man verwendet Verstärker mit schrittweise einstellbarer Verstärkung. Soll der Einstellbereich viele Dezibel umfassen und über einen großen Fequenzbereich, z.B. über einen Frequenzbereich zwischen einer halben und einer Oktave, mit engen Toleranzen erfolgen, dann sind die Regelcharakteristiken von Transistoren für diesen Zweck zu ungenau und die Schaltungen zu schmalbandig. Mechanische Umschalter zur Einstellung der Verstärkung scheiden aus Platz- und Kostengründen für viele Gebiete der Mikrowellentechnik aus.

Der vorliegenden Erfindung liegt die Aufgabe zugrunde, eine stufenweise einstellbare Kettenleiteranordnung der eingangs genannten Art anzugeben, mit der die Forderungen nach extremer Kleinheit, Fernbedienbarkeit, großer Bandbreite, guter Reproduzierbarkeit in großen Stückzahlen, niedrigen Kosten und geringer Einfügedämpfung erfüllt werden können.

Diese Aufgabe wird erfindungsgemäß durch eine stufenweise einstellbare Kettenleiteranordnung nach dem Anspruch 1 gelöst.

Steuerbare Dual-Gate-MOS FET's in Kettenverstärkern sind bereits aus IEEE Transactions on Electron Devices, Band ED-31, Nr. 12, Dezember 1984, Seiten 1926–1930, bekannt.

Eine stufenweise einstellbare Kettenleiteranordnung nach dem Anspruch 1 kann als monolithisch integrierbare Schaltung verwirklicht werden.

Mit der erfindungsgemäßen speziellen Kettenverstärkeranordnung werden nicht nur die bei der der Erfindung zugrunde gelegten Aufgaben genannten Probleme gelöst, vielmehr ergeben sich noch eine Reihe weiterer Vorteile, die bisher nur mit großem Aufwand oder auf Kosten anderer wichtiger Schaltungsparameter erreicht werden konnten. Diese Vorteile sind in der folgenden Beschreibung näher dargestellt. Entsprechende Ausgestaltungen der Erfindung ergeben sich aus Unteransprüchen.

Eine stufenweise Kettenleiteranordnung nach der Erfindung eignet sich als Hochfrequenz- und Mikrowellen-Verstärker/Abschwächer für Phased Array-Radargeräte, Richtfunkgeräte, Meßgeräte.

Bei der erfindungsgemäßen stufenweise einstellbaren Kettenleiteranordnung wird als stufenweise einstellbares Verstärkungs- bzw. Dämpfungs-Zweitor eine spezielle "Kettenverstärker"-Schaltung verwendet.

Beim Kettenverstärker ("Distributed Amplifier" DA) tragen die gesteuerten Quellen additiv zur Ausgangsgröße (Strom oder Spannung) bei. Die mit DA üblicherweise erreichbare große Bandbreite ist für die hier betrachtete Anwendung nur ein erwünschter Nebeneffekt; entscheidend ist jedoch die Quantisierbarkeit der Verstärkung je nach Anzahl der gesteuerten Quellen (Transistoren), wobei die Maximalverstärkung unter Umständen auch kleiner als eins sein darf (Gewinn $G \gtrless 0$ dB).

Da die grundsätzlichen Eigenschaften eines Kettenverstärkers (DA) erhalten bleiben, wenn die einzelnen Quellen unterschiedlich stark sind oder auch teilweise keine Leistung abgeben, kann durch Zu-oder Abschalten einzelner oder mehrerer Quellen die Verstärkung schrittweise erhöht bzw. erniedrigt werden. Ein besonderer Vorteil dieses Prinzips ist, daß in der Verstärkerkette auch Transistoren mit schrittweise zunehmender Steilheit verwendet werden können, wodurch beim Zu- oder Abschalten einzelner Transistoren Verstärkungsänderungen unterschiedlicher Schrittweite erzielt werden können.

Die zur phasenrichtigen Ansteuerung der Transistor-Eingänge bzw. zur Aufsummierung der Transistor-Ausgangsströme erforderlichen Verzögerungsglieder sind grundsätzlich mit konzentrierten Reaktanzen realisierbar; im Mikrowellengebiet verwendet man jedoch vorteilhaft "Transmission Lines", wodurch die Anordnung voll monolithisch integrierbar wird und sich durch die Miniaturisierung leicht in den Signalweg auch sehr kompakter Baugruppen einfügen läßt.

Eine solche Anordnung eignet sich daher sowohl als stufenweise einstellbarer Verstärker als auch für stufenweise einstellbare Abschwächer; in beiden Fällen kann die Änderung von Schritt zu Schritt entweder konstant sein oder nach einem (weitgehend) frei wählbaren Kurvenverlauf (z.B. logarithmisch) erfolgen.

Die genannten nichtlinearen Stufungen sind mit Linearkombinationen von Dämpfungsgliedern nicht erreichbar, wenn mit n Gliedern $2^n$ Dämpfungsschritte gefordert werden. So können z.B. mit 4 Dämpfungsgliedern bei einer Linearkombination von Dämpfungsgliedern (4-Bit-Auflösung) nur 15 Dämpfungswerte mit konstanter Schrittweite erzielt werden. Eine stetige Zu- oder Abnahme der Schrittweite ist bei Linearkombinationen von Dämpfungsgliedern nicht möglich.

Bei Kettenverstärkern (DA) mit wahlweiser Zu- oder Abschaltbarkeit einzelner Quellen sind als schaltbare Quellen vorteilhaft Dual Gate-Feldeffekttransistoren (DG FET) verwendbar, deren erstes Gate $G_1$ als Signal-Gate und deren zweites Gate $G_2$ als Steuer-Gate verwendet wird. Für die genannte nicht-lineare Stufung der Verstärkung bzw. Abschwächung können die Gateweiten von Transistor zu Transistor entsprechend gestaffelt werden. Für Mikrowellenbetrieb sind vorteilhaft Galliumarsenid-Dual Gate-Feldeffekttransistoren (GaAs-DG FET) zu verwenden.

Beim Abschalten einzelner Feldeffekttransistoren würde vor allem an den Drain-Anschlüssen für die Verzögerungsleitungen jeweils eine Stoßstelle auftreten. Zur Vermeidung dieser Stoßstellen ist es zweckmäßig, jeweils zwei parallele DGFET in jeder Stufe zu verwenden, wovon ein DGFET an seinem Signal-Gate $G_1$ keine Signalspannung erhält; in jeder Stufe werden diese jeweils zwei parallelen DGFET abwechselnd eingeschaltet. Wenn eine Stufe des Kettenverstärkers aktiviert ist, ist der zu dieser Stufe gehörende DGFET, an dessen Signal-Gate $G_1$ die Signalspannung anliegt, in Betrieb; wenn diese Stufe des Kettenverstärkers ausgeschaltet ist, ist der andere zu dieser Stufe gehörende, parallele DGFET, an dessen Signal-Gate $G_1$ keine Signalspannung anliegt, aktiviert.

Wenn beide DGFET einer Stufe des Kettenverstärkers jeweils gleiche Bauelemente-Strukturen haben, bleibt die Belastung der Drain-Verzögerungsleitung konstant, unabhängig vom Schaltzustand der betreffenden Stufe des Kettenverstärkers.

Ein besonderer Vorteil einer stufenweise einstellbaren Kettenleiteranordnung nach der Erfindung besteht ferner darin, daß (bei gleicher Steilheit aller Feldeffekttransistoren) die Phase des Ausgangssignals nicht verändert wird, wenn einer oder mehrere Feldeffekttransistoren zu- oder abgeschaltet werden. Bei ungleicher Steilheit der jeweiligen Stufen des Kettenverstärkers ist der jeweilige Phasensprung im Ausgangssignals aufgrund des Zu- oder Abschaltens eines Feldeffektransistors nur ein kleiner Bruchteil der Phasendrehung einer Einzelstufe des Kettenverstärkers. Die Erfindung wird an Hand der Zeichnung näher erläutert.

Fig. 1 zeigt das Prinzip einer stufenweise einstellbaren Kettenleiteranordnung nach der Erfindung.

Fig. 2 zeigt eine Einzelheit einer stufenweise einstellbaren Kettenleiteranordnung mit zwei parallelen Dual Gate-Feldeffekttransistoren in einer Stufe.

Fig. 3 zeigt ein Ersatzschaltbild für eine Kettenleiteranordnung mit nur einer Stufe.

Fig. 4 zeigt ein Ersatzschaltbild für eine stufenweise einstellbare Kettenleiteranordnung mit 3 Stufen.

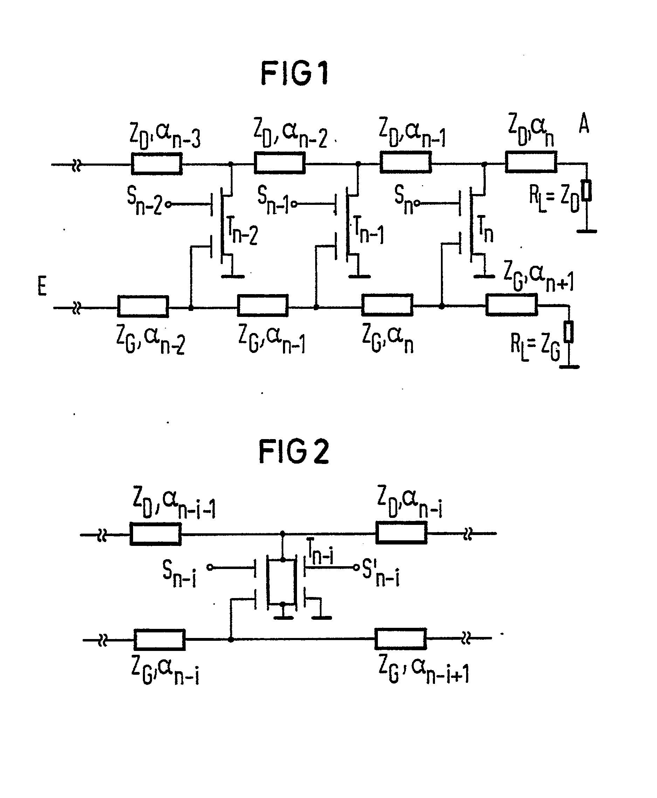

Fig. 1 zeigt das Prinzip einer stufenweise einstellbaren Kettenleiteranordnung bestehend aus Verzögerungsgliedern $Z_G$, $Z_D$ und einer Anzahl gesteuerter Qellen $T_n$, $T_{n-1}$, $T_{n-2}$, einem Signal-Eingang E und einem Signal-Ausgang A nach Art eines Kettenverstärkers (Distributed Amplifier = DA). Die gesteuerten Quellen $T_n$, $T_{n-1}$, $T_{n-2}$ sind über die Steuer-Anschlüsse $S_n$, $S_{n-1}$, $S_{n-2}$ wahlweise zu- und abschaltbar. Als gesteuerte Quellen werden Dual-Gate-Feldeffekttransistoren (DGFET) ($T_1 ... T_n$) verwendet. Das jeweils erste Gate $G_1$ der Dual-Gate-Feldeffekttransistoren ($T_1 ... T_n$) liegt jeweils über Verzögerungsglieder $Z_G$ an der Signalspannung des Signal-Eingangs E. Das jeweils zweite Gate $G_2$ der jeweiligen Dual-Gate-Feldeffekttransistoren ($T_1 ... T_n$) liegt über die jeweiligen Steueranschlüsse ($S_1 ... S_n$) jeweils an geeigneten Gleichspannungen zum Zu- oder Abschalten des jeweiligen Dual-Gate-Feldeffekttransistors ($T_1 ... T_n$).

Die jeweiligen Source-Anschlüsse der jeweiligen Dual-Gate-Feldeffekttransistoren ($T_1 ... T_n$) sind im Ausführungsbeispiel nach Fig. 1 auf Erdpotential gelegt.

Die Verzögerungsglieder $Z_D$, $Z_G$ rufen jeweils eine Phasendrehung des hindurchfließenden Stromes hervor. Die jeweilige Phasendrehung des jeweiligen Verzögerungsgliedes $Z_{Dm}$, $Z_{Gm}$, m∈ $\{1, ..., n + 1\}$ ist beim jeweiligen Verzögerungsglied mit $\alpha_1 \ldots \alpha_{n+1}$ bezeichnet. Sowohl die Drain-Verzögerungsleitung als auch die Signal-Verzögerungsleitung sind jeweils mit einem Widerstand $R_L$ abgeschlossen.

Fig. 2 zeigt einen Ausschnitt einer schrittweise einstellbaren Kettenleiteranordnung mit einer Stufe $T_{n-i}$, die zwei parallele Dual-Gate-Feldefektransistoren aufweist. Beim Abschalten einzelner Feldeffekttransistoren würde vor allem an den Drain-Anschlüssen für die Verzögerungsleitungen jeweils eine Stoßstelle auftreten. Zur Vermeidung dieser Stoßstellen ist es vorteilhaft, jeweils zwei parallele Dual-Gate-Feldeffekttransistoren in jeder Stufe ($T_1 \ldots T_n$) zu verwenden, wovon einer der beiden parallelen Dual-Gate-Feldeffekttransistoren an seinem ersten Gate $G_1$ keine Signalspannung erhält. Diese beiden parallelen Dual-Gate-Feldeffekttransistoren einer einzelnen Stufe werden abwechselnd über die Anschlüsse $S_{n-i}$ bzw. $S'_{n-i}$ eingeschaltet. Bei einer aktiven Stufe $T_{n-i}$ ist der Dual-Gate Feldeffekttransistor, der an seinem ersten Gate $G_1$ an die Signal-Verzögerungsleitung angeschlossen ist, in Betrieb, bei ausgeschalteter Stufe ist der dazu parallele Dual-Gate-Feldeffekttransistor, dessen erstes $G_1$ im Ausführungsbeispiel auf Erdpotential gelegt ist, aktiviert. Wenn beide Dual-Gate-Feldeffekttransistoren einer einzelnen Stufe jeweils gleiche Schalteigenschaften haben, bleibt die Belastung der Drain-Verzögerungsleitung konstant, unabhängig vom Schaltzustand der einzelnen Stufe.

Ein besonderer Vorteil einer Anordnung nach Fig. 2 besteht ferner darin, daß bei gleicher Steilheit aller Dual-Gate-Feldeffekttransistoren die Phase des Ausgangssignals A nicht verändert wird, wenn eine oder mehrere gesteuerte Quellen zu- oder abgeschaltet werden. Bei ungleicher Steilheit der Stufen ist der jeweilige Phasensprung bei der Phase des Ausgangssignals A nur ein kleiner Bruchteil der Phasendrehung einer Einzelstufe.

Für die Steuerspannungen $S_{n-i}$, $S'_{n-i}$ an den jeweils zweiten Gates $G_2$ der beiden parallelen Dual-Gate-Feldeffekttransistoren gemäß Fig. 2 gilt beispielsweise:

Wenn die Stufe $T_{n-i}$ aktiv ist, liegt der Steueranschluß $S_{n-i}$ auf einem Potential +4 V und der Steueranschluß $S'_{n-i}$ auf einem Potential -4 V.

Wenn die Stufe $T_{n-i}$ von Fig. 2 nicht aktiv ist, liegt der Steueranschluß $S_{n-i}$ auf einem Potential -4 V und der Steueranschluß $S'_{n-i}$ auf einem Potential +4 V.

Die Stoßstellen auf der Gate-Verzögerungsleitung sind beim Sperren des zweiten Gates $G_2$ nicht so ausgeprägt wie Stoßstellen ausgeprägt sein würden, die beim Sperren des jeweils zweiten Gates $G_2$ auf der Drain-Verzögerungsleitung auftreten würden. Die Stoßstellen auf der Gate-Verzögerungsleitung lassen sich ebenfalls vermindern, wenn man die Signal-Gates ($G_1$) der jeweiligen ersten Transistorsysteme, deren erstes Gate $G_1$ jeweils an die Signalspannung angeschlossen ist, nur lose an die Gate-Verzögerungsleitung ankoppelt und gegebenenfalls entsprechende Ausgleichswiderstände anordnet. Eine lose Ankopplung ist in diesem Fall zulässig, weil bei der gewünschten Anwendung die Leistungsverstärkung nur etwa eins sein muß und weil keine hohen Anforderungen an die Rauschzahl gestellt werden müssen (NF $\leq$ 12 dB).

Vorteilhaferweise können die jeweils parallel geschalteten Dual-Gate-Feldeffekttransistor-Systeme einer jeden Stufe ($T_1 \ldots T_n$) zu einem Doppel-Dual-Gate-Feldeffekttransistor mit gemeinsamer Source- und gemeinsamer Drain-Zone integriert werden.

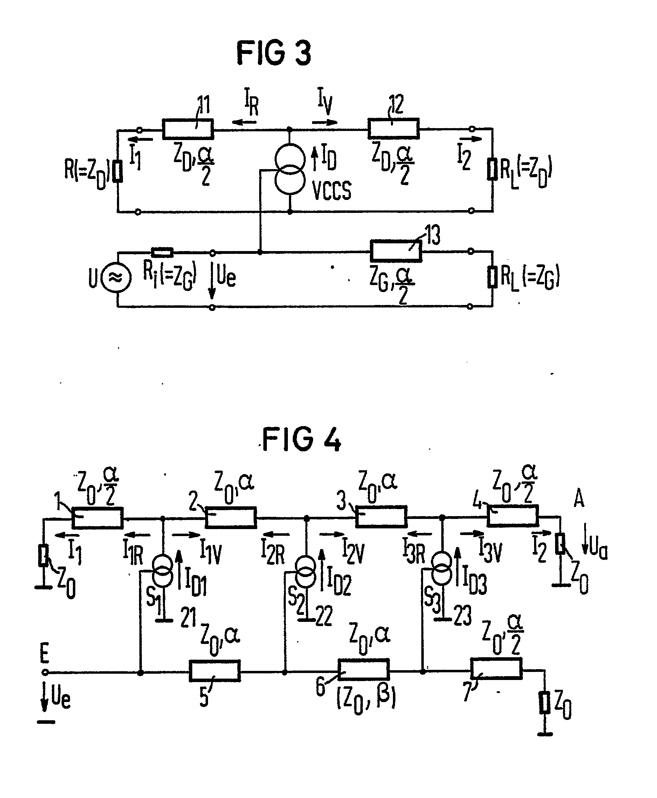

Für eine erste näherungsweise Berechnung einer schrittweise einstellbaren Kettenleiteranordnung nach Fig. 1 können die Dual-Gate-Feldeffekttransistoren als spannungsgesteuerte Stromquellen (VCCS = Voltage Controlled Current Source) aufgefaßt werden. Für nur eine Stufe $T_1$ ergibt sich dabei das Ersatzschaltbild nach Fig. 3.

Fig. 3 zeigt eine gesteuerte Quelle VCCS mit Verzögerungsgliedern 11, 12, 13. Die Verzögerungsglieder 11, 12, 13 verursachen jeweils eine Phasendrehung $\alpha/2$ bei einem das jeweilige Verzögerungsglied 11, 12, 13 durchfließenden Strom. Die Verzögerungsglieder 11, 12 besitzen jeweils den Wellenwiderstand $Z_D$. Das Verzögerungsglied 13 besitzt den Wellenwiderstand $Z_G$. In der spannungsgesteuerten Stromquelle VCCS wird der Strom $I_D$ hervorgerufen, der durch die Drain-Elektrode der jeweiligen Transistorstufe fließt. Dieser Strom $I_D$ teilt sich in einen Rückstrom $I_R$ und einen Vorwärtsstrom $I_V$. Der Rückstrom $I_R$ fließt durch das Verzögerungsglied 11 und durch einen Abschlußwiderstand R, dessen Widerstandswert gleich $Z_D$ ist. Der Vorwärtsstrom $I_V$ fließt durch das Verzögerungsglied 12 und durch den Abschlußwiderstand $R_L$, dessen Widerstandswert ebensfalls gleich $Z_D$ ist.

Die spannungsgesteuerte Stromquelle VCCS wird von der Signal-Eingangsspannung $U_e$, die am Signaleingang E anliegt, gesteuert. Die Signal-Eingangsspannung $U_e$ wird in einer Spannungsquelle U erzeugt, die einen Innenwiderstand $R_i$ mit einem Widerstandswert $Z_G$ aufweist. Die Signal-Eingangsspannung $U_e$ liegt außerdem an einer Reihenschaltung bestehend aus dem Verzögerungsglied 13 und dem Abschlußwiderstand $R_L$ an. Das Verzögerungsglied 13 besitzt den Widerstandswert $Z_G$ und den Phasenwinkel $\alpha/2$. Der Abschlußwiderstand $R_L$, der in Reihe zum Verzögerungsglied 13 geschaltet ist, besitzt den Widerstandswert $Z_G$.

Die spannungsgesteuerte Stromquelle VCCS besitzt die Steilheit S. Damit ergibt sich für den Strom $I_1$, der über das Verzögerungsglied 11 in den Widerstand R fließt, folgende Beziehung:

$$I_1 = I_D/2 = (U_e \cdot S \cdot e^{-j \cdot \alpha/2})/2$$

Für den Strom $I_2$ durch das Verzögerungsglied 12 und den in Reihe zum Verzögerungsglied 12 geschalteten Abschlußwiderstand $R_L$ gilt:

$$I_2 = I_D /2 = (U_e . S . e^{-j.\alpha/2}) /2.$$

Bei mehreren Stufen in der Kettenleiteranordnung addieren sich die Vorwärtsströme, während bei geeigneter Wahl der elektrischen Leitungslängen (Transmision Lines) die Rückwärtsströme sich gegenseitig kompensieren.

Fig. 4 zeigt eine Kettenleiteranordnung mit drei spannungsgesteuerten Stromquellen 21, 22, 23. Die Drain-Verzögerungsleitung weist dabei die Verzögerungsglieder 1, 2, 3, 4 auf. Die Signal-Verzögerungsleitung weist die Verzögerungsglieder 5, 6, 7 auf. Im Beispiel nach Fig. 4 haben alle im Beispiel als verlustfrei angenommenen Verzögerungsglieder denselben reellen Wellenwiderstand $Z_0$. Die Verzögerungsglieder 1, 4, 7 haben den Phasenwinkel $\alpha/2$. Die Verzögerungsglieder 2, 3, 5 haben den Phasenwinkel $\alpha$. Das Verzögerungsglied 6 hat in einem im folgenden näher besprochenen Ausführungsbeispiel den Phasenwinkel $\alpha$ und in einem anderen im folgenden näher Besprochenen Ausführungsbeispiel den Phasenwinkel $\beta$, der in diesem anderen Ausführungsbeispiel verschieden vom Phasenwinkel $\alpha$ ist. Die Drain-Verzögerungsleitung ist sowohl an ihrem Anfang als auch an ihrem Ende jeweils mit einem Widerstand abgeschlossen, der jeweils den Widerstandswert $Z_0$ aufweist. Parallel zum Abschlußwiderstand am Ausgang der Drain-Verzögerungsleitung kann die Signal-Ausgangsspannung $U_a$ abgenommen werden.

Am Eingang E der Signalverzögerungsleitung liegt die Signaleingangsspannung $U_e$ an. Die Signalverzögerungsleitung ist an ihrem Ende ebenfalls mit einem Abschlußwiderstand abgeschlossen, der ebenfalls den Widerstandswert $Z_0$ aufweist.

Die Beziehungen zwischen den Phasenwinkeln der Verzögerungsglieder auf der Drain-Verzögerungsleitung und auf der Signalverzögerungsleitung sind in den Figuren 3 und 4 unterschiedlich zu den Beziehungen zwischen den Phasenwinkeln, wie sie in Fig. 1 angegeben sind. Die in Fig. 1 angegebenen Beziehungen zwischen diesen Phasenwinkeln sind nur beispielhaft und nicht verbindlich. Wie in den Figuren 3 und 4 gezeigt, können die Beziehungen zwischen diesen Phasenwinkeln der jeweiligen Verzögerungsglieder im Einzelfall nach speziellen Erfordernissen angepaßt werden.

Die spannungsgesteuerten Stromquellen 21, 22, 23 in Fig. 4 besitzen jeweils die Steilheit $S_1$, $S_2$, $S_3$. Die Stromquellen 21, 22, 23 erzeugen jeweils die Drain-Ströme $I_{D1}$, $I_{D2}$, $I_{D3}$.

Die von den Stromquellen 21, 22, 23 jeweils erzeugten Drain-Ströme werden jeweils in einen Vorwärtsstrom und in einen Rückstrom aufgeteilt. Beispielsweise wird der von der Stromquelle 21 erzeugte Drain-Strom $I_{D1}$ aufgeteilt in den Vorwärtsstrom $I_{1V}$ und in den Rückstrom $I_{1R}$.

Von der Stromquelle 21 ausgehend fließt ein Rückstrom durch das Verzögerungsglied 1 und ein Vorwärtsstrom durch die Verzögerungsglieder 2, 3, 4. Von der Stromquelle 22 ausgehend fließt ein Rückstrom durch die Verzögerungsglieder 2, 1 und ein Vorwärtsstrom durch die Verzögerungsglieder 3,4. Von der Stromquelle 23 ausgehend fließt ein Rückstrom durch die Verzögerungsglieder 3, 2, 1 und ein Vorwärtsstrom durch das Verzögerungsglied 4.

Die Steuerleitungen für die spannungsgesteuerten Stromquellen 21, 22, 23 sind an die Signalverzögerungsleitung angeschlossen. Zwischen den Steuerspannungsanschlüssen der Stromquellen 21, 22 an die Signalverzögerungsleitung liegt das Verzögerungsglied 5. Zwischen den Steuerspannungsanschlüssen der Stromquellen 22, 23 an die Signalverzögerungsleitung liegt das Verzögerungsglied 6. Zwischen dem Steuerspannungsanschluß der Stromquelle 23 an die Signalverzögerungsleitung und dem Abschlußwiderstand der Singalverzögerungsleitung liegt das Verzögerungsglied 7.

Anhand der in Fig. 4 dargestellten Kettenstruktur sollen die Zusammenhänge zwischen den Strömen und Spannungen und den Steilheiten $S_i$ der einzelnen Transistoren erläutert werden. Dabei sind die folgenden Fälle berücksichtigt:

1. Alle Steilheiten $S_i$ sind gleich groß. In diesem Fall haben die Leitungen (Transmission lines, Verzögerungsglieder) den Phasenwinkel $\alpha$ oder $\alpha/2$.

2. Die Steilheit wenigstens eines Transistors ist verschieden von den Steilheiten der anderen Transistoren. Wenn beim Beispiel nach Fig. 4 die Stromquelle 23 eine Steilheit $S_3$ aufweist, die sowohl verschieden von der Steilheit $S_1$ der Stromquelle 21 als auch verschieden von der Steilheit $S_2$ der Stromquelle 22 ist, dann muß im Beispiel nach Fig. 4 das Verzögerungsglied 6 (Transmission line) eine Phasendrehung $\beta$, die verschieden von der Phasendrehung $\alpha$ ist, hervorrufen, um den Strom $I_1$, der durch das Verzögerungsglied 1 und dem Abschlußwiderstand am Anfang der Drainverzögerungsleitung fließt, zu minimieren oder ganz zu eliminieren.

Bei der Kettenstruktur nach Fig. 4 gelten folgende Gleichungen:

(1) $I_{1R} = I_{1V} = I_{D1}/2; \ldots$

(2) $I_1 = (I_{D1} . e^{-j\alpha/2}) /2 + (I_{2R} . e^{-j3\alpha/2}) /2 + (I_{3R} . e^{-j5\alpha/2}) /2$

(3) $I_1 = 0$ für $S_1 + S_2 \cdot e^{-j2\alpha} + S_3 \cdot e^{-j4\alpha} = 0$

$S_1 = S_2 = S_3 : \alpha = 60°$

(4) $I_2 = I_{1V} \cdot e^{-j5\alpha/2} + I_{2V} \cdot e^{-j3\alpha/2} + I_{3V} \cdot e^{-j\alpha/2} = (U_e \cdot e^{-j5\alpha/2}) \cdot (S_1 + S_2 + S_3) / 2; \; S_1 = S_2 = S_3 = S:$

$$I_2 = \frac{3}{2} S \cdot U_e \cdot e^{-j5\alpha/2};$$

Wenn alle Steilheiten $S_i$ der einzelnen Transistoren bei der Kettenstruktur nach Fig. 4 gleich groß sind, kann auch das Verzögerungsglied 6 den Phasenwinkel $\alpha$ besitzen. In diesem Fall ergibt sich ein Phasenwinkel $\alpha$ von 60° beim Beispiel nach Fig. 4, damit der Gesamtrückstrom $I_1$ verschwindet.

Wenn zumindest eine Steilheit $S_i$ eines einzelnen Transistors verschieden ist von den Steilheiten der übrigen Transistoren, so ergibt sich für das Verschwinden des Gesamtrückstroms $I_1$ folgende Bedingung:

(5) $I_1 = 0: S_1 + S_2 . \cos 2\alpha + S_3 . \cos (3\alpha + \beta) = 0$

$S_2 . \sin 2\alpha + S_3 . \sin (3\alpha + \beta) = 0$

Diese Bedingung läßt sich nur dann erfüllen, wenn das Verzögerungsglied 6 eine Phasendrehung $\beta$ hervorruft, die verschieden von der Phasendrehung $\alpha$ ist. Wenn die Verzögerungsglieder 5, 6 als Transmission lines verwirklicht werden, bedeutet dies, daß die Leitungen 5, 6 unterschiedlich lang sein müssen.

Wenn das Verzögerungsglied 6 eine Phasendrehung $\beta$ aufweist, ergibt sich für den Gesamtvorwärtsstrom $I_2$, der am Signalausgang A der Drainverzögerungsleitung fließt, folgende Gleichung:

$$(5a) \quad I_2 = \frac{U_e}{2} \cdot e^{-j3\alpha/2} (S_1 \cdot e^{-j\alpha} + S_2 \cdot e^{-j\alpha} + S_3 \cdot e^{-j\beta}).$$

Wie sich aus den Gleichungen (4) und (5a) ergibt, ist der Gesamtvorwärtsstrom $I_2$ stets kleiner oder gleich der halben Steilheitssumme, multipliziert mit der Eingangsspannung $U_e$. Der Gesamtrückwärtsstrom $I_1$ wird von der zweiten Hälfte der Steilheitssumme aufgebracht. Auch wenn der Gesamtrückwärtsstrom $I_1$ verschwindet, wird der Gesamtvorwärtsstrom $I_2$ nicht größer als es in den Gleichungen (4) bzw. (5a) angegeben ist. Wenn daher beim Abschalten einzelner Quellen in einer Kettenleiteranordnung der Gesamtvorwärtsstrom $I_2$ verkleinert wird, ist die Änderung des Gesamtvorwärtsstromes $I_2$ unabhängig von der gleichzeitig erfolgenden Änderung des Gesamtrückwärtsstromes $I_1$.

Für den Phasengang bei einer Kettenleiteranordnung mit n-Stufen läßt sich folgendes sagen:

Für den Fall, daß alle Steilheiten $S_i$ aller Transistorstufen gleich groß sind, ergibt sich, daß die Phase $\varphi (I_2)$ des Gesamtvorwärtsstromes $I_2$ proportional zur Stufenzahl n ist:

$$(6) \quad \varphi (I_2) = \frac{n+2}{2} \cdot \alpha \cdot \qquad n = 1, 2, 3, \ldots$$

wobei $\alpha$ entsprechend der im folgenden angegebenen Gleichung (7) mit steigender Stufenzahl abnimmt.

Bei Veralgemeinerung des Ergebnisses der Gleichung (3) auf n-Stufen ergibt sich:

$2.n.\alpha = 360°$, also

$$(7) \quad \alpha = \frac{180°}{n}.$$

Beim Zu- oder Abschalten einer Stufe ändert sich die Phase des Gesamtvorwärtsstromes $I_2$ überhaupt nicht.

Für unterschiedliche Steilheiten der Transistorstufen ergibt sich folgendes:

Solange die Steilheit einer einzelnen Transistorstufe nicht größer ist als die Summe aller Steilheiten der übrigen Transistorstufen, gibt es immer eindeutige Lösungen für die elektrischen Längen der Leitungen (Verzögerungsglieder), so daß der Gesamtrückwärtsstrom $I_1$ verschwindet. Für eine Kettenleiteranordnung mit 3 Stufen benötigt man zwei verschiedene Leitungslängen ($\alpha,\beta$), für eine Kettenleiteranordnung mit 4 Transistorstufen benötigt man drei verschiedene Leitungslängen ($\alpha,\beta,\gamma$) usw. Für eine Kettenleiteranordnung mit N-Transistorstufen sind N-1 verschiedene Leitungslängen erforderlich, wenn alle Steilheiten der einzelnen Transistorstufen paarweise voneinander verschieden sind. Damit ergibt sich beim Zu- oder Abschalten einer Transistorstufe jeweils ein kleiner Phasensprung, dessen Höhe vom Unterschied der Steilheiten der einzelnen Transistorstufen abhängt. Auf jeden Fall ist der Phasensprung beim Gesamtvorwärtsstrom $I_2$ wesentlich kleiner als die einzelnen Phasenwinkel $\alpha$, $\beta$, $\gamma$, ... usw. der einzelnen Verzögerungsglieder. Außerdem nehmen diese Phasensprünge beim Gesamtvorwärtsstrom $I_2$ mit steigender Stufenzahl der Gesamtkettenleiteranordnung ab.

Die aufgezeigten prizipiellen Eigenschaften von Kettenverstärkern und die vorteilhaften Eigenschaften von Dual-Gate-Feldeffektransistoren zur Realisierung der gesteuerten Quellen machen diesen Schaltungstyp mit den erfindungsgemäßen Modifizierungen für digital einstellbare Mikrowellen-Abschwächer besonders geeignet, und eine monolithische Integration ist mit mäßigen Toleranzanforderungen möglich.

Die elektrische Länge der Verzögerungsleitungen muß bei 4 bit-Auflösung (=16 Stufen) nur jeweils ca. $\lambda_\varepsilon/32$ umfassen. Dieser Wert verkürzt sich wegen der elektrischen Verlängerung der Leitungen infolge der FET-Kapazitäten noch erheblich, so daß man mit ca. $\lambda_\varepsilon/40$ Leitungslänge auskommt. Bei einer Frequenz von beispielsweise 10 GHz entspricht dies bei einer Realisierung der Kettenleiteranordnung auf Galium-Arsenid einer Leitungslänge von ca. 100 μm. Dies ist ein wirtschaftlich vertretbarer Wert.

Literatur:

(1) Meinke-Gundlach:
"Taschenbuch der Hochfrequenztechnik" S. 947, 1202.
(2) Malbon, R.M., Osbrink, N.K.,
"Small-Signal Low-Noise Active Devices"
Microwave Journal, Feb. 1985, PP. 121 ... 137
(3) Midford, T.A.:
"Solid-State, Broadband Power Amplifiers for Electronic Warfare Applications" Micowave Journal, Feb. 1985, pp. 85 ... 116
(4) Ayasli, Y., Mozzi, R.L., Vorhaus, J.L. Reynolds, L.D., Pucel, R.A.:
"A Monolithic GaAs 1-13 GHz Traveling-Wave Wave Amplifier"
IEEE Trans. On Electron Devices, Vol.ED-29, No 7 July 1982
(5) Strid E.W.:
"A Monolithic 10-GHz Vector Modulator"
IEEE - GaAs IC Symposium 1983 Conf. digest pp. 109 - 111.

## Bezugszeichenliste

$Z_G$, $Z_D$ Verzögerungsglieder
$T_n$ gesteuerte Quelle
E Signal-Eingang
A Signal-Ausgang
$S_n$ Steueranschluß
$T_n$ Dual-Gate-Feldeffekttransistor
$R_L$ Abschluß-Widerstand
VCCS spannungsgesteuerte Stromquelle
11, 12, 13 Verzögerungsglieder
$I_D$ Strom der spannungsgesteuerten Stromquelle VCCS
$I_R$ Rückstrom
$I_V$ Vorwärtsstrom
R Abschluß-Widerstand
$U_e$ Signal-Eingangsspannung
U Spannungsquelle
$R_i$ Innenwiderstand der Spannungsquelle U
21, 22, 23 spannungsgesteuerte Stromquellen
1, 2, 3, 4 Verzögerungsglieder der Drain-Verzögerungsleitung
5, 6, 7 Verzögerungsglieder der Signal-Verzögerungsleitung
$U_a$ Signal-Ausgangsspannung
$S_1$, $S_2$, $S_3$ Steilheiten der spannungsgesteuerten Stromquellen 21, 22, 23
$I_{D1}$, $I_{D2}$, $I_{D3}$ Drain-Ströme der Stromquellen 21, 22, 23
$I_{1V}$, $I_{2V}$, $I_{3V}$ Vorwärtsströme der Stromquellen 21, 22, 23
$I_{1R}$, $I_{2R}$, $I_{3R}$ Rückströme der Stromquellen 21, 22, 23
$I_1$ Gesamtrückstrom
$I_2$ Gesamtvorwärtsstrom

## Patentansprüche

1. Stufenweise einstellbare Kettenleiteranordnung bestehend aus Verzögerungsgliedern ($Z_{Gm}$, $Z_{Dm}$, $m\varepsilon\{1, ..., n+1\}$) und einer Anzahl gesteuerter Quellen ($T_1 ... T_n$; VCCS), einem Signal-Eingang (E) und einem Signal-Ausgang (A) nach Art eines Kettenverstärkers (Distributed Amplifier) mit einer Verzögerungsleitung im Ausgangskreis, gekennzeichnet dadurch, daß

a) die gesteuerten Quellen (VCCS) einzeln wahlweise zu- und abschaltbar sind, und daß

b) als gesteuerte Quellen Dual-Gate-FET ($T_1$ ... $T_n$) verwendet werden, deren erstes Gate ($G_1$) jeweils über Verzögerungsglieder ($Z_{Gm}$) an der Eingangs-Signalspannung liegt und deren zweites Gate ($G_2$) jeweils an geeigneten Gleichspannungen zum Zu- oder Abschalten der jeweiligen FET anliegt.

2. Stufenweise einstellbare Kettenleiteranordnung nach Anspruch 1, dadurch gekennzeichnet, daß zur Vermeidung von Impedanzsprüngen beim Zu- bzw. Abschalten einzelner oder mehrerer gesteuerter Quellen (VCCS) zu jeder Quelle parallel ein zweites Transistorsystem angeordnet ist, dessen erstes Gate ($G_1$) nicht an die Singalspannung angeschlossen ist und dessen zweites Gate ($G_2$) eine solche Schaltspannung erhält, daß dieses zweite Transistorsystem stets stromlos ist, wenn der parallel liegende mit Signalspannung beaufschlagte erste FET aktiv ist, und daß dieses zweite Transistorsystem aktiv ist, wenn der parallel liegende, mit Signalspannung beaufschlagte FET Transistor stromlos ist.

3. Stufenweise einstellbare Kettenleiteranordnung nach Anspruch 2, dadurch gekennzeichnet, daß die jeweils parallel geschalteten Dual-Gate-FET-Systeme bei der jeweiligen Stufe zu einem Doppel-Dual-Gate-FET mit gemeinsamer Source- und gemeinsamer Drain-Zone integriert sind.

4. Stufenweise einstellbare Kettenleiteranordnung nach einem der Ansprüche 1 bis 3, dadurch gekennzeichent, daß die Steilheit der gesteuerten Quellen so bemessen ist, daß sich beim Zu- oder Abschalten jeder weiteren Quelle jeweils gleichgroße Verstärkungssprünge ergeben.

5. Stufenweise einstellbare Kettenleiteranordnung nach einem der Ansprüche 1 bis 3, dadurch gekennzeichnet, daß die Steilheiten der einzelnen Transistoren so bemessen sind, daß die Verstärkungssprünge beim aufeinanderfolgenden Zuschalten der Transistoren $T_1$, $T_2$, ... $T_n$ jeweils stetig zunehmen oder abnehmen.

6. Stufenweise einstellbare Kettenleiteranordnung nach einem der Ansprüche 1 bis 5, dadurch gekennzeichnet, daß die Zahl der gesteuerten Quellen mindestens so groß ist wie die Zahl der gewünschten Verstärkungsschritte.

7. Stufenweise einstellbare Kettenleiteranordnung nach einem der Ansprüche 1 bis 6, dadurch gekennzeichnet, daß die Steilheiten der als gesteuerte Quellen verwendeten DG-FET so bemessen sind, daß sich bei Einschalten aller Quellen die gewünschte Maximalverstärkung ergibt.

8. Stufenweise einstellbare Kettenleiteranordnung nach einem der Ansprüche 1 bis 5, dadurch gekennzeichnet, daß so viele gesteuerte Quellen jeweils zu- oder abschaltbar sind, wie dem gewünschten Unterschied in der Verstärkung entspricht.

## Claims

1. Series network arrangement adjustable in stages, consisting of delay sections ($Z_{Gm}$, $Z_{Dm}$, $m\varepsilon\{1,...,n+1\}$) and a number of controlled sources ($T_1...T_n$; VCCS), a signal input (E) and a signal output (A) in the manner of a distributed amplifier comprising a delay line in the output circuit, characterized in that

a) the controlled sources (VCCS) can be individually optionally connected and disconnected, and in that

b) dual-gate FETs ($T_1...T_n$) are used as controlled sources, the first gate ($G_1$) of which is in each case connected via delay sections ($Z_{Gm}$) to the input signal voltage and the second gate ($G_2$) of which is in each case connected to suitable direct voltages for connecting or disconnecting the respective FETs.

2. Series network arrangement adjustable in stages according to Claim 1, characterized in that, in order to avoid impedance jumps during the connection or disconnection of individual or several controlled sources (VCCS), in parallel with each source a second transistor system is arranged, the first gate ($G_1$) of which is not connected to the signal voltage and the second gate ($G_2$) of which receives such a switching voltage that this second transistor system is always without current when the parallel-connected first FET, to which the signal voltage is applied, is active, and in that this second transistor system is active when the parallel-connected FET transistor, to which the signal voltage is applied, is without current.

3. Series network arrangement adjustable in stages according to Claim 2, characterized in that the dual-gate FET systems connected in parallel in each case are integrated to form a double dual-gate FET with common source and common drain zone in the respective stage.

4. Series network arrangement adjustable in stages according to one of Claims 1 to 3, characterized in that the slope of the controlled sources is dimensioned in such a manner that gain jumps of the same magnitude are obtained in each case when each further source is connected or disconnected.

5. Series network arrangement adjustable in stages according to one of Claims 1 to 3, characterized in that the slopes of the individual transistors are dimensioned in such a manner that the gain jumps in each case continuously increase or decrease when the transistors $T_1$, $T_2$, ...$T_n$ are successively connected.

6. Series network arrangement adjustable in stages according to one of Claims 1 to 5, characterized in that the number of controlled sources is at least as large as the number of the desired gain steps.

7. Series network arrangement adjustable in stages according to one of Claims 1 to 6, characterized in that the slopes of the DG-FETs used as controlled sources are dimensioned in such a manner that the desired maximum gain is obtained when all sources are switched on.

8. Series network arrangement adjustable in stages according to one of Claims 1 to 5, characterized in that in each case a number of controlled sources which corresponds to the desired difference in gain can be connected or disconnected.

**Revendications**

1. Dispositif formant système itératif réglable de façon échelonnée et constitué par des circuits de retardement ($Z_{Gm}$, $Z_{Dm}$, $m_\varepsilon\{1, ..., n+1\}$) et une multiplicité de sources commandées ($T_1 ... t_n$; VCCS), une entrée (E) des signaux et une sortie (A) des signaux, à la manière d'un amplificateur distribué (Distributed Amplifier) comportant une ligne à retard dans le circuit de sortie, caractérisé par le fait que
a) les sources commandées (VCCS) peuvent être raccordées et déconnectées individuellement au choix, et que
b) comme sources commandées, on utilise des transistors FET à double grille (Dual-Gate-FET) ($T_1 ...$ $T_n$), dont la première grille ($G_1$) est placée à la tension du signal d'entrée, par l'intermédiaire de circuits de retardement ($Z_{Gm}$) et dont la seconde grille ($G_2$) est placée à des tensions continues appropriées permettant le raccordement ou la déconnexion des transistors FET respectifs.

2. Dispositif formant système itératif réglable de façon échelonnée suivant la revendication 1, caractérisé par le fait que pour éviter des sauts d'impédance lors du raccordement ou de la déconnexion de sources individuelles commandées (VCCS) ou de plusieurs de ces sources, en parallèle avec chaque source est branché un second système à transistor, dont la première grille ($G_1$) n'est pas placée à la tension de signal et dont la seconde grille ($G_2$) reçoit une tension de commutation telle que ce second système à transistor est en permanence sans courant lorsque le premier transistor FET branché en parallèle et chargé par la tension de signal est actif, et que ce second système à transistor est actif lorsque le transistor FET branché en parallèle et chargé par la tension de signal, n'est pas alimenté en courant.

3. Dispositif formant système itératif réglable de façon échelonnée suivant la revendication 2, caractérisé par le fait que les systèmes Dual-Gate-FET branchés respectivement en parallèle sont intégrés, pour l'étage respectif, de manière à former un double transistor FET Dual-Gate comportant une zone de source commune et une zone de drain commune.

4. Dispositif formant système itératif réglable de façon échelonnée suivant l'une des revendications 1 à 3, caractérisé par le fait que la pente des sources commandées est dimensionnée de manière que lors du raccordement ou de la déconnexion de chaque autre source, on obtient des variations brusques respectives d'amplification, de même amplitude.

5. Dispositif formant système itératif réglable de façon échelonnée suivant l'une des revendications 1 à 3, caractérisé par le fait que les pentes des différents transistors sont dimensionnées de manière que les variations brusques d'amplification lors du raccordement successif des transistors ($T_1$, $T_2$ ... $T_n$) augmentent ou diminuent d'une manière continue.

6. Dispositif formant système itératif réglable de façon échelonnée suivant l'une des revendications 1 à 5, caractérisé par le fait que le nombre des sources commandées est au moins égal au nombre des pas d'amplification désirés.

7. Dispositif formant système itératif réglable de façon échelonnée suivant l'une des revendications 1 à 6, caractérisé par le fait que les pentes des transistors DG-FET utilisés en tant que sources commandées sont dimensionnées de manière que lors du branchement de toutes les sources, on obtienne l'amplification maximale désirée.

8. Dispositif formant système itératif réglable de façon échelonnée selon l'une des revendications 1 à 5, caractérisé par le fait que l'on peut respectivement brancher ou déconnecter le nombre de sources commandées qui correspond à la différence désirée d'amplification.

## FIG 1

## FIG 2

## FIG 3

## FIG 4